# EUROPÄISCHE PATENTANMELDUNG

(11) **EP 1 235 271 A2**
(43) Veröffentlichungstag der Anmeldung: **28.08.2002**
(21) Anmeldenummer: 02003678.6
(22) Anmeldetag: 18.02.2002
(51) Int. Cl.: H01L 21/762, H01L 21/336, H01L 29/78

(54) **Nativer Feldeffekttransistor und Verfahren zu dessen Herstellung**

(30) Priorität: 23.02.2001 DE 10108923
(71) Anmelder: Infineon Technologies AG, 81669 München (DE)
(72) Erfinder: Abdul-Hak, Ayad, 01108 Dresden (DE); Gratz, Achim, 98587 Steinbach-Hallenberg (DE); Kutter, Christoph, Dr., 01099 Dresden (DE); Caspary, Dirk, 01109 Dresden (DE); Haibach, Patrick, Dr., 01099 Dresden (DE); Stein Von Kamienski, Elard, Dr., 01099 Dresden (DE)
(74) Vertreter: Kindermann, Peter, Dipl.-Ing.

(57) **Zusammenfassung**

Die Erfindung bezieht sich auf einen nativen Feldeffekttransistor (NT) sowie ein dazugehöriges Herstellungsverfahren, wobei ein komplementärer Kanalstoppbereich (KKS) im wesentlichen unterhalb von Isolationsgebieten (I) in einem Substrat (1) ausgebildet ist, der eine gleiche Dotierung aufweist wie ein von den Isolationsgebieten (I) begrenzter Kanalbereich K des nativen Feldeffekttransistors (NT).

## Beschreibung

Die vorliegende Erfindung bezieht sich auf einen nativen Feldeffekttransistor und ein Verfahren zu dessen Herstellung und insbesondere auf einen nativen Feldeffekttransistor sowie ein dazu gehöriges Herstellungsverfahren, bei dem eine Schwellenspannung des Transistors mittels Kanalstoppbereichen eingestellt wird.

Bei der Herstellung von integrierten Schaltungen werden eine Vielzahl von Halbleiterschaltelementen ausgebildet, die beispielsweise Feldeffekttransistoren aufweisen und eine vorbestimmte Schwellenspannung betragsmäßig größer 0 Volt, üblicherweise ein bestimmter Bruchteil der Betriebsspannung, besitzen. Die Festlegung der Schwellspannung ist ein komplexer, dem Fachmann aber hinlänglich bekannter Vorgang, so dass hier nicht näher darauf eingegangen werden soll. An typischerweise sehr wenigen Stellen der Halbleiterschaltung ist jedoch der Einsatz von sogenannten nativen Feldeffekttransistoren, deren Schwellenspannung nahe 0 Volt liegt, sehr vorteilhaft bzw. erwünscht.

Zur Realisierung derartiger nativer Feldeffekttransistoren bzw. Transistoren mit einer Schwellenspannung nahe 0 Volt sind eine Vielzahl von technologischen Einflussgrößen grundsätzlich verwendbar, jedoch wegen einer Verkoppelung zu anderen Hauptparametern des Schaltelements bzw. des Transistors nicht frei einstellbar. Eine zusätzliche Schwellenspannungsimplantation für die nativen Feldeffekttransistoren lässt sich daher meist nicht umgehen, wodurch des weiteren mindestens eine zusätzliche Masken- und Lithographie-Ebene benötigt wird und sich die Herstellungskosten erhöhen.

Ein derartiges herkömmliches Verfahren zur Herstellung von nativen Feldeffekttransistoren ist beispielsweise aus der Druckschrift US 6,063,663 bekannt, bei der zur Realisierung einer Schwellenspannung nahe 0 Volt eine schwache LVS-Implantation in Kanalbereichen des auszubildenden Transistors durchgeführt wird. Hierbei wird unter Verwendung einer zusätzlichen Maske die Oberfläche des Kanalbereichs source- und drainseitig derart implantiert, dass sich eine Schwellenspannung nahe 0 Volt und somit ein nativer Feldeffekttransistor ergibt. Auf Grund der zusätzlichen Masken- bzw. Lithographie-Ebene und der zusätzlich verwendeten Implantation erhöhen sich jedoch bei derartigen herkömmlichen Herstellungsverfahren die Kosten sowie die Komplexität des Verfahrens.

Der Erfindung liegt daher die Aufgabe zu Grunde, einen nativen Feldeffekttransistor und ein dazugehöriges Herstellungsverfahren zu schaffen, bei dem die Kosten reduziert sind und das Verfahren vereinfacht wird.

Erfindungsgemäß wird diese Aufgabe hinsichtlich des Feldeffekttransistors durch die Merkmale des Patentanspruchs 1 und hinsichtlich des Verfahrens durch die Maßnahmen des Patentanspruchs 6 gelöst.

Insbesondere durch die Verwendung von komplementären Kanalstoppbereichen, die im Wesentlichen unterhalb der Isolationsgebiete im Substrat ausgebildet sind und eine Dotierung vom gleichen Leitungstyp aufweisen wie ein Kanalbereich bzw. die Source- und Draingebiete des Feldeffekttransistors, erhält man unter Nutzung von Kanalweiteneffekten ohne zusätzliche Masken-, Lithographie- und Implantationsschritte einen nativen Feldeffekttransistor, dessen Schwellenspannung nahe 0 Volt liegt.

Die komplementären Kanalstoppbereiche werden hierbei mit der gleichen Maske und unter Nutzung der Kanalstopp-Implantation des komplementären Feldeffekttransistors ausgebildet wie herkömmliche Kanalstoppbereiche, die zur Verbesserung einer Isolationsfähigkeit der Feldeffekttransistoren untereinander sowie zur Unterdrückung von Kanalweiteneffekten z.B. dem sogenannten "narrow-channel-effect" (NCE) eingesetzt werden. Auf diese Weise kann ein nativer Feldeffekttransistor besonders kostengünstig hergestellt werden.

Vorzugsweise erstrecken sich die komplementären Kanalstoppbereiche bis in den Kanalbereich des Feldeffekttransistors, wodurch sich eine sehr genaue Einstellung der Schwellenspannung nahe 0 Volt für den nativen Feldeffekttransistor ergibt. Das Dotierprofil wird dabei so gewählt, dass dabei kein zusätzlicher pn-Übergang im Kanalbereich des Transitors entsteht, sondern lediglich die Nettodotierung des Kanalbereiches geeignet moduliert wird.

Zusätzlich zu dem komplementären Kanalstoppbereich kann jedoch auch ein herkömmlicher Kanalstoppbereich unterhalb der Isolationsgebiete im Substrat ausgebildet werden, welcher eine zur Dotierung des Kanalbereichs bzw. der Source- und Draingebiete entgegengesetzte Dotierung aufweist. Da bei einem derartigen Verfahren für alle in der Halbleiterschaltung existierenden Feldeffekttransistoren sowohl ein herkömmlicher als auch ein komplementärer Kanalstoppbereich ausgebildet werden kann, können die Kosten weiter verringert werden.

Vorzugsweise werden die Kanalstoppbereiche sowie die komplementären Kanalstoppbereiche mittels einer Implantation unter Verwendung der gleichen Kanalstopp-Masken ausgebildet, da derartige Herstellungsschritte ohnehin in einer Vielzahl von Standardprozessen zur Verfügung stehen.

Alternativ können jedoch die Kanalstoppbereiche und/oder die komplementären Kanalstoppbereiche auch mittels Molekularstrahlepitaxie, Vorbelegung mit Dotanden usw. im Substrat ausgebildet werden. Zur weiteren Einstellung der komplementären Kanalstoppbereiche können diese mittels thermischer Behandlung bis in den Kanalbereich ausdiffundiert werden. Auf diese Weise kann unter Verwendung des im jeweiligen Prozess zur Verfügung stehenden Temperaturbudgets die Schwellspannung nahe 0 Volt eingestellt werden.

Bei Durchführung einer Doppelimplantation für den Kanalstoppbereich sowie für den komplementären Kanalstoppbereich (d.h. der native Transistor wird sowohl mit komplementärem als auch herkömmlichen Kanalstoppbereich ausgeführt) kann eine Kanalstopp-Maske relativ zur anderen derart positioniert werden, dass sich für die jeweiligen Kanalstoppbereiche unterschiedliche Dotierprofile ergeben.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
Figur 1 eine vereinfachte Draufsicht eines nativen Feldeffekttransistors gemäß einem ersten Ausführungsbeispiel;
Figur 2 eine vereinfachte Schnittansicht des nativen Feldeffekttransistors gemäß Figur 1 entlang eines Schnitts I-I';
Figur 3 eine vereinfachte Schnittansicht des nativen Feldeffekttransistors gemäß Figur 1 entlang eines Schnitts II-II';
Figuren 4A bis 4C vereinfachte Schnittansichten zur Darstellung wesentlicher Verfahrensschritte bei der Herstellung eines nativen Feldeffekttransistors gemäß einem zweiten Ausführungsbeispiel;
Figur 5 eine vereinfachte Schnittansicht eines nativen Feldeffekttransistors gemäß einem dritten Ausführungsbeispiel; und
Figur 6 eine graphische Darstellung einer Schwellenspannung über einer Kanalweite in Abhängigkeit von jeweiligen Kanalstoppbereichen und Isolationsgebieten.

Zur Realisierung von nativen Feldeffekttransistoren bzw. einem dazugehörigen Herstellungsverfahren bedient sich die vorliegende Erfindung dem sogenannten Schmalkanal- bzw. narrowchannel-Effekt (NCE), wobei durch die erfindungsgemäßen Maßnahmen der NCE technisch nutzbar gemacht wird. Insbesondere MOS-Transistoren mit kleiner Kanalweite weisen eine niedrigere Schwellenspannung Vₜₕ auf als solche mit großer Kanalweite. Dieses Phänomen ist als "narrow-channel-effect" oder "narrow-width-effect" bekannt und wird insbesondere durch physikalische Effekte an den seitlichen Begrenzungen des Kanals hervorgerufen. Bei kleineren Kanalweiten werden diese Effekte stärker wirksam.

Zur Unterdrückung derartiger Kanalweiteneffekte (NCE) werden in hochintegrierten Halbleiterschaltungen daher üblicherweise Kanalstoppbereiche an den Seiten des Kanals ausgebildet, die eine Ausbreitung des Kanals über die seitlichen Begrenzungen, die beispielsweise aus Isolationsgebieten bestehen, des Transistors hinaus verhindert. Diese Kanalstoppbereiche werden vorzugsweise durch eine sogenannte Kanalstopp-Implantation unter Verwendung einer dazugehörigen Kanalstopp-Maske derart eingestellt, dass eine gewiss Anzahl von Dotierstoffen seitlich in den Transistor bzw. Kanal eindiffundiert und eine Schwellenspannung im seitlichen Teil des Kanals anhebt. Auf diese Weise werden die Eigenschaften von Transistoren mit. großer Kanalweite praktisch nicht verändert, während jedoch die betragsmäßige Verringerung der Schwellenspannung bei Transistoren mit kleiner Kanalweite kompensiert werden kann. Dieser Kanalweiteneffekt kann somit effektiv mittels Kanalstoppbereichen unterdrückt werden. Dabei verschiebt sich der Einsatzpunkt des NCE hin zu kleineren Kanalweiten.

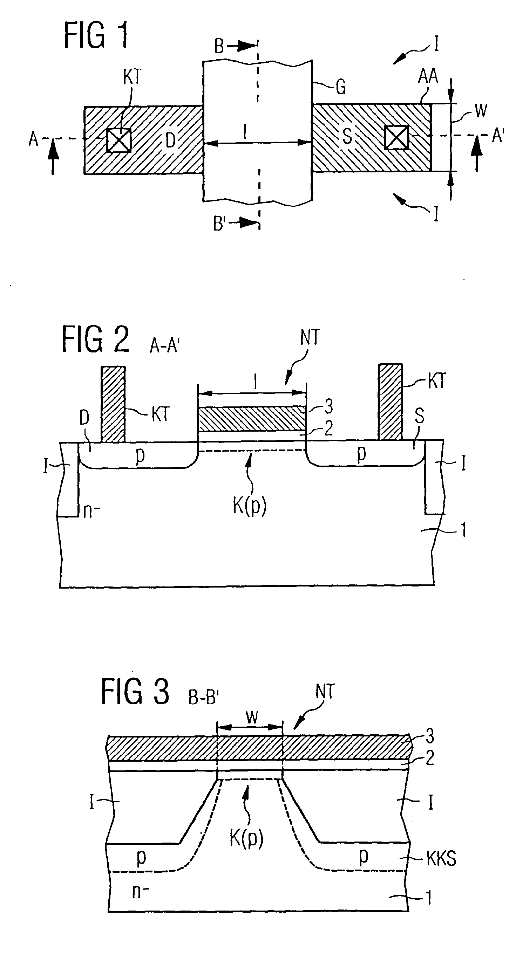

Die erfindungsgemäße Ausbildung von zu den vorstehend beschriebenen Kanalstoppbereichen entgegengesetzten d.h. komplementären Kanalstoppbereichen kann nunmehr dazu genutzt werden, die Schwellenspannung eines relativ schmalen Transistors (kleine Kanalweite) gezielt abzusenken und somit einen nativen Feldeffekttransistor ohne zusätzliche Masken- und Lithographie-Ebenen zu erzeugen. Die Herstellungskosten werden dadurch wesentlich verringert. Das für den NCE charakteristische Abfallen der Schwellenspannung mit kleiner werdender Weite wird dabei dahingehend beeinflusst, dass über einen technologisch beherrschbaren Bereich der Weite w eine abgesenkte Schwellenspannung eingestellt wird. Ohne diese Maßnahmen gelingt es im Rahmen der stets vorhandenen Fertigungstoleranzen nicht, den NCE technisch zu nutzen, da bezüglich einer Schwellenspannung nahe 0V aufgrund der steilen Kennlinie die erforderliche Stabilität nicht erreicht werden kann. Figur 1 zeigt eine vereinfachte Draufsicht eines nativen Feldeffekttransistors mit derart geringer Kanalweite w, dass vorstehend beschriebene Kanalweiteneffekte auftreten. Die Figuren 2 und 3 zeigen vereinfachte Schnittansichten dieses nativen Feldeffekttransistors gemäß einem ersten Ausführungsbeispiel entlang Schnitten I-I' und II-II' in Figur 1.

Gemäß Figuren 1 bis 3 werden in einem Substrat 1, welches beispielsweise aus einem Silizium-Halbleitersubstrat besteht, aktive Bereiche AA mittels Isolationsgebieten I im Halbleitersubstrat 1 ausgebildet. Die Breite der aktiven Bereiche AA legt hierbei auch eine Kanalweite w eines Kanalbereichs K des nativen Feldeffekttransistors NT fest. Gemäß Figur 2 und 3 ist das Substrat 1 beispielsweise n⁻-dotiert.

Oberhalb des aktiven Bereichs AA und des Kanalbereichs K befindet sich eine Schichtenfolge aus einer Isolierschicht 2, welche beispielsweise aus einer thermisch ausgebildeten Siliziumdioxidschicht besteht, und einer Steuerschicht 3, die Polysilizium oder eine metallische Schicht aufweist. Die Schichten 2 und 3 bilden hierbei einen Gatestapel G mit einer Breite 1 aus, die im Wesentlichen eine Kanallänge des Kanalbereichs K festlegt. An den Seiten des Gatestapels G befinden sich im aktiven Bereich AA Source- und Draingebiete S und D, welche gemäß Figur 2 beispielsweise p-dotiert sind, und demzufolge ein p-Kanal-Feldeffekttransistor ausgebildet wird. Zum Anschließen der Source- und Draingebiete S und D sind gemäß Figuren 1 und 2 Kontakte KT ausgebildet, welche beispielsweise als metallische Via-Kontakte realisiert sind, jedoch auch durch andere Anschlusskontakte, beispielsweise über Polysiliziumbahnen oder Diffusionsbahnen im Substrat 1, realisiert werden können.

Gemäß Figur 3 werden die Isolationsgebiete I zur Ausbildung der aktiven Bereiche AA und zum Festlegen der Kanalweite w des Kanalbereichs K beispielsweise durch flache Grabenisolierungen (shallow trench isolation, STI) ausgebildet. Sie können jedoch in gleicher Weise auch durch sogenannte LOCOS-Isolationsgebiete oder andere Isolationsformen ausgebildet werden. Wie vorstehend beschrieben wurde, treten insbesondere bei Feldeffekttransistoren mit sehr kleinen Kanalweiten w sogenannte Kanalweiteneffekte bzw. "narrow-channel-Effekte" auf, weshalb zu deren Kompensation in herkömmlichen Prozessen Kanalstoppbereiche unterhalb der Isolationsgebiete I an den Seiten des Kanalbereichs K ausgebildet werden. Diese Kanalstoppbereiche besitzen eine Dotierung, die zur Dotierung des Kanalbereichs K bzw. der dazugehörigen Source- und Draingebiete entgegengesetzt ist.

Gemäß Figur 3 wird erfindungsgemäß zur Erzeugung eines nativen Transistors an Stelle der Kanalstoppbereiche nunmehr ein komplementärer Kanalstoppbereich KKS unterhalb der Isolationsgebiete I ausgebildet, dessen Dotierung vom gleichen Leitungstyp (beispielsweise p) ist wie die Dotierung des Kanalbereichs K bzw. der dazugehörigen Source- und Draingebiete S, D des Feldeffekttransistors. Auf diese Weise wird die Schwellenspannung des Feldeffekttransistors auf nahe 0 Volt gesenkt, so dass man einen nativen Feldeffekttransistor erhält. Die Herstellungskosten bzw. der Aufwand hierfür ist sehr gering, da keine zusätzlichen Implantations-, Masken- und Lithographie-Schritte eingefügt werden müssen und vielmehr unter Verwendung der ohnehin zur Verfügung stehenden Kanalstopp-Maske für den komplementären Transistor lediglich ein komplementärer Kanalstoppbereich ausgebildet werden muss.

Gemäß Figur 3 erstreckt sich der komplementäre Kanalstoppbereich KKS hierbei vorzugsweise bis in den Kanalbereich K bzw. den seitlichen Teil des Kanalbereichs, wodurch sich eine besonders effektive Senkung der Schwellenspannung Vₜₕ ergibt.

Nachfolgend wird ein Verfahren zur Herstellung von nativen Feldeffekttransistoren beschrieben.

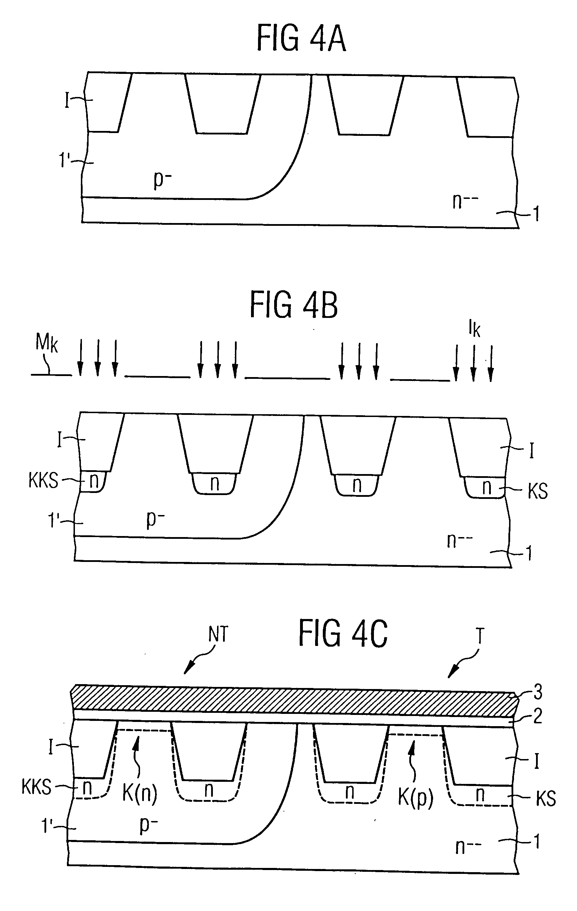

Figuren 4A bis 4C zeigen vereinfachte Schnittansichten zur Veranschaulichung von wesentlichen Herstellungsschritten eines nativen Feldeffekttransistors gemäß einem zweiten Ausführungsbeispiel. Gleiche Bezugszeichen bezeichnen hierbei gleiche oder ähnliche Schichten bzw. Elemente, weshalb nachfolgend auf eine detaillierte Beschreibung verzichtet wird.

Da sich die vorliegende Erfindung nicht nur auf p-MOS-Feldeffekttransistoren bezieht, sondern auch n-MOS-Transistoren, CMOS-Transistoren sowie Hochvolt-Transistoren usw. umfasst, werden gemäß Figur 4A in ersten Herstellungsschritten nach dem Ausbilden der Isolationsgebiete I, die vorzugsweise STI-Isolationsgebiete darstellen, Wannengebiete 1' im Substrat 1 ausgebildet. Gemäß Figur 4A wird in einem n⁻⁻-Halbleitersubstrat 1 eine p⁻ - Wanne 1' für einen nativen Feldeffekttransistor beispielsweise durch Implantation ausgebildet. Auf eine detaillierte Beschreibung zur Herstellung derartiger Isolationsgebiete und/oder Wannengebiete wird nachfolgend verzichtet, da sie dem Fachmann allgemein bekannt sind.

Gemäß Figur 4B werden nach dem Ausbilden der aktiven Bereiche durch die Isolationsgebiete I und dem Ausbilden von jeweiligen Wannen 1' unter Verwendung einer Kanalstopp-Maske M_{K} und einer dazugehörigen Implantation I_{K} Kanalstoppbereiche KS und komplementäre Kanalstoppbereiche KKS im Substrat 1 bzw. in der p⁻-Wanne 1' unterhalb der jeweiligen Isolationsgebiete I ausgebildet. Die komplementären Kanalstoppbereiche KKS als auch die normalen Kanalstoppbereiche KS sind hierbei n-leitend, wirken jedoch auf die nachfolgend ausgebildeten Feldeffekttransistoren unterschiedlich, da deren Kanalbereiche vom gleichen Leitungstyp oder vom unterschiedlichen Leitungstyp sind.

Gemäß Figur 4C werden in nachfolgenden Schritten eine Isolierschicht 2 beispielsweise als Siliziumdioxidschicht thermisch ausgebildet und darüber eine aus Polysilizium oder metallischem Material bestehende Steuerschicht 3 beispielsweise mittels eines chemischen Dampfabscheideverfahrens abgeschieden. Nach einer Strukturierung von jeweiligen Gatestapeln erfolgt anschließend eine jeweilige Source-Drain-Dotierung, wobei für den nativen Feldeffekttransistor NT n-dotierte Source- und Draingebiete zur Erzeugung eines n-leitenden Kanalbereichs K ausgebildet werden, während für den herkömmlichen Feldeffekttransistor T eine p-Dotierung zur Erzeugung von p-dotierten Source- und Draingebieten sowie eines dazu gehörigen p-Kanalbereichs erfolgt.

Da die Kanalstoppdotierung im nativen Feldeffekttransistor die gleiche Dotierung besitzt bzw. vom gleichen Leitungstyp ist wie der Kanalbereich K, spricht man hierbei von einem komplementären Kanalstoppbereich KKS. Demgegenüber ist die Kanalstoppdotierung für den herkömmlichen Feldeffekttransistor T entgegengesetzt zum Leitungstyp p des Kanalbereichs K, weshalb es sich hierbei um herkömmliche Kanalstoppbereiche KS handelt. Die Wirkung dieser Kanalstoppbereiche ist jedoch unterschiedlich. Während der Kanalstoppbereich KS im Feldeffekttransistor T lediglich die Kanalweiteneffekte verringert und eine zuverlässige Begrenzung des Kanalbereichs K ermöglicht, wird durch die komplementären Kanalstoppbereiche KKS im nativen Feldeffekttransistor NT die Schwellenspannung bis nahe 0 Volt abgesenkt.

Gemäß Figuren 4B und 4C erhält man eine besonders exakte Einstellung der Schwellenspannung im nativen Feldeffekttransistor, wenn insbesondere die komplementären Kanalstoppbereiche KKS beispielsweise mittels temperaturbedingter Diffusion bis an den Kanalbereich K herangeführt werden. Eine gleichermaßen in den herkömmlichen Transistoren T stattfindende Ausdiffusion ist hierbei für die Kanalstoppbereiche KS sowie die Eigenschaften im Kanalbereich K unbedeutend, wenn die Maske für den Kanalstoppbereich KS hinreichenden Abstand zum Kanal K des Transistors T hat. Der Abstand eines Kanalstoppbereiches KS wird daher vorzugsweise größer als der eines komplementären Kanalstoppbereiches KKS gewählt.

Auf diese Weise kann unter Verwendung von bereits existierenden Masken und Implantationsschritten die Realisierung von nativen Feldeffekttransistoren besonders einfach und kostengünstig durchgeführt werden.

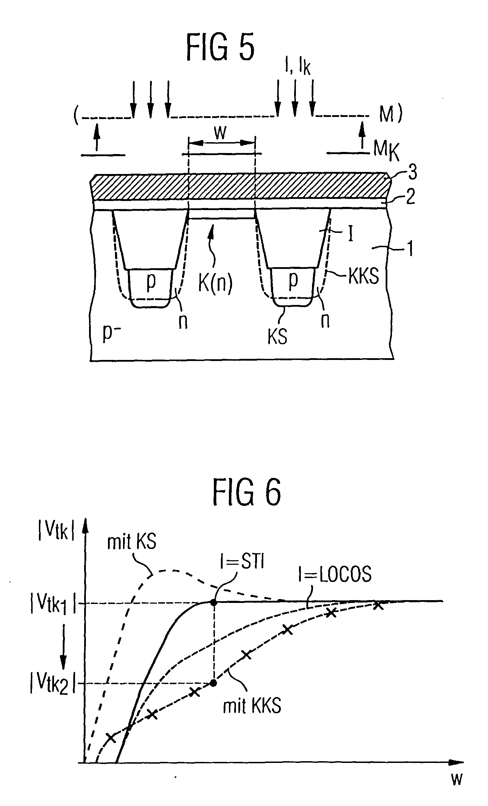

Figur 5 zeigt eine vereinfachte Schnittansicht eines nativen Feldeffekttransistors gemäß einem dritten Ausführungsbeispiel, wobei gleiche Bezugszeichen wiederum gleiche oder ähnliche Schichten bzw. Elemente bezeichnen und auf ihre wiederholte Beschreibung nachfolgend verzichtet wird.

Gemäß Figur 5 kann im nativen Transistor nicht nur ein komplementärer Kanalstoppbereich KKS im Wesentlichen unterhalb der Isolationsgebiete I ausgebildet werden, sondern darüber hinaus ein herkömmlicher Kanalstoppbereich KS existieren. Dies erfolgt unter Verwendung der vorhandenen Masken und für die Kanalstoppbereiche der Transistoren eines bestimmten sowie des dazu komplementären Leitungstyps, wobei die Maskenöffnungen sich teilweise oder vollständig überlappen, um das in Fig. 5 schematisch dargestellt Dotierprofil zu erzeugen.

Alternativ zu den vorstehend beschriebenen Implantationsverfahren zum Ausbilden der Kanalstoppbereiche und komplementären Kanalstoppbereiche können auch andere Verfahren wie z.B. die Molekularstrahlepitaxie zum Ausbilden dieser Bereiche verwendet werden. Auf diese Weise lassen sich die in jeweiligen Standardprozessen vorhandenen Verfahrensschritte optimal für das Ausbilden der komplementären Kanalstoppbereiche verwenden.

Figur 6 zeigt eine vereinfachte Darstellung einer Schwellenspannung Vₜₕ in Abhängigkeit von einer jeweiligen Kanalweite w des Feldeffekttransistors, wobei die Einflüsse eines Kanalstoppbereichs KS, eines komplementären Kanalstoppbereichs KKS, einer STI-Isolierung und einer LOCOS-Isolierung dargestellt sind. Gemäß der vorliegenden Erfindung kann demzufolge bei Verwendung einer STI-Grabenisolierung und eines komplementären Kanalstoppbereichs KKS eine Schwellenspannung Vₜₕ₁ auf den Betrag Vₜₕ₂ verringert werden, wodurch sich die erwünschten und oftmals notwendigen nativen Feldeffekttransistoren ergeben. Gemäß Figur 6 ist ferner ersichtlich, dass insbesondere bei Feldeffekttransistoren mit einer geringen Kanalweite w, bei der Kanalweiteneffekte auftreten, eine besonders große Wirkung durch die komplementären Kanalstoppbereiche zu erzielen ist.

Die vorliegende Erfindung wurde anhand von speziell dotierten p-Gebieten bzw. -Wannen beschrieben. Sie umfasst jedoch in gleicher Weise entgegengesetzt dotierte Gebiete bzw. Wannen sowie weitere Kombinationen der vorstehend beschriebenen Ausführungsbeispiele. Ferner wurde die vorliegende Erfindung anhand eines MOS-Feldeffekttransistors beschrieben. Sie ist jedoch nicht darauf beschränkt, sondern umfasst in gleicher Weise Halbleiterbauelemente mit Feldeffekttransistorstrukturen wie z.B. EEPROMS, FLASH-Speicherzellen usw. In gleicher Weise kann das Ausbilden der Isolationsgebiete auch zu einem anderen insbesondere späteren Zeitpunkt erfolgen.

## Patentansprüche

1. Nativer Feldeffekttransistor mit
Isolationsgebieten (I) zum Ausbilden von aktiven Bereichen (AA) in einem Substrat (1) und zum Festlegen einer Kanalweite (w) eines Kanalbereichs (K);
Source- und Draingebieten (S, D) von einem ersten Leitungstyp, die zum Festlegen einer Kanallänge (1) des Kanalbereichs (K) im aktiven Bereich (AA) ausgebildet sind;
einer Isolierschicht (2), die zumindest über dem Kanalbereich (K) ausgebildet ist; und
einer Steuerschicht (3) zum Ansteuern des nativen Feldeffekttransistors (NT), **gekennzeichnet durch** einen komplementären Kanalstoppbereich (KKS), der im Wesentlichen unterhalb der Isolationsgebiete (I) im Substrat 1 ausgebildet ist und eine Dotierung vom ersten Leitungstyp aufweist.

2. Nativer Feldeffekttransistor nach Patentanspruch 1,
**dadurch gekennzeichnet, dass** der komplementäre Kanalstoppbereich (KKS) sich bis in den Kanalbereich (K) erstreckt.

3. Nativer Feldeffekttransistor nach Patentanspruch 1 oder 2,
**gekennzeichnet durch** einen Kanalstoppbereich (KS), der im Wesentlichen unterhalb der Isolationsgebiete (I) im Substrat 1 ausgebildet ist und eine Dotierung von zum ersten Leitungstyp entgegengesetzten zweiten Leitungstyp aufweist.

4. Nativer Feldeffekttransistor nach einem der Patentansprüche 1 bis 3,
**dadurch gekennzeichnet, dass** er in einer Wanne (1') vom zweiten Leitungstyp ausgebildet ist.

5. Nativer Feldeffekttransistor nach einem der Patentansprüche 1 bis 4,
**dadurch gekennzeichnet, dass** die Kanalweite (w) des nativen Feldeffekttransistors (NT) eine Größe aufweist, bei der Kanalweiteneffekte auftreten.

6. Verfahren zur Herstellung eines nativen Feldeffekttransistors (NT) mit den Schritten:
a) Ausbilden von Isolationsgebieten (I) in einem Substrat (1) zum Erzeugen von aktiven Bereichen (AA) und zum Festlegen einer Kanalweite (w) eines Kanalbereichs (K);
b) Ausbilden von komplementären Kanalstoppbereichen (KKS) von einem ersten Leitungstyp unterhalb der Isolationsgebiete (I) im Substrat (1);
c) Ausbilden einer Isolierschicht (2) an zumindest der Oberfläche der aktiven Bereiche (AA);
d) Ausbilden einer Steuerschicht (3) an zumindest der Oberfläche der Isolierschicht (2);
e) Strukturieren der Steuerschicht (3) und der Isolierschicht (2) zum Ausbilden von Gatestapeln (6);
f) Ausbilden von Source- und Draingebieten (S, D) vom ersten Leitungstyp zum Festlegen einer Kanallänge (1) des Kanalbereichs (K) im aktiven Bereich (AA); und
g) Ausbilden von Kontakten (KT) zum Anschließen der Sourceund Draingebiete (S, D).

7. Verfahren nach Patentanspruch 6,
**dadurch gekennzeichnet, dass** in Schritt a) STI und/oder LOCOS-Isolationsgebiete (I) ausgebildet werden.

8. Verfahren nach Patentanspruch 6 oder 7,
**gekennzeichnet durch** den weiteren Schritt b1) Ausbilden von Kanalstoppbereichen (KS) von einem zweiten zum ersten Leitungstyp entgegengesetzten Leitungstyp unterhalb der Isolätionsgebiete (I) im Substrat (1).

9. Verfahren nach einem der Patentansprüche 6 bis 8,
**dadurch gekennzeichnet, dass** die Kanalstoppbereiche (KS) und/oder die komplementären Kanalstoppbereiche (KKS) mittels Implantation (I, Iₖ) unter Verwendung von Kanalstopp-Masken (M, Mₖ) ausgebildet werden.

10. Verfahren nach einem der Patentansprüche 6 bis 8,
**dadurch gekennzeichnet, dass** die Kanalstoppbereiche (KS) und/oder die komplementären Kanalstoppbereiche (KKS) mittels Molekularstrahlepitaxie im Substrat (1) ausgebildet werden.

11. Verfahren nach einem der Patentansprüche 6 bis 10,
**dadurch gekennzeichnet, dass** in Schritt b) die komplementären Kanalstoppbereiche (KKS) mittels Diffusion bis an den Kanalbereich (K) herangeführt werden.

12. Verfahren nach einem der Patentansprüche 6 bis 11,
**dadurch gekennzeichnet, dass** in Schritt c) eine SiO₂-Schicht thermisch ausgebildet wird.

13. Verfahren nach einem der Patentansprüche 6 bis 12,
**dadurch gekennzeichnet, dass** in Schritt f) die Source- und Draingebiete (S, D) mittels einer Implantation unter Verwendung des Gatestapels (G) als Maske selbstjustierend ausgebildet werden.

14. Verfahren nach einem der Patentansprüche 6 bis 13,
**dadurch gekennzeichnet, dass** die Kanalweite (w) des nativen Feldeffekttransistors (NT) eine Größe aufweist, bei der Kanalweiteneffekte auftreten.
